# EUROPÄISCHE PATENTANMELDUNG

(11) **EP 1 026 724 A2**
(43) Veröffentlichungstag der Anmeldung: **09.08.2000**
(21) Anmeldenummer: 00101555.1
(22) Anmeldetag: 27.01.2000
(51) Int. Cl.: H01L 21/00, H01L 31/18

(54) **Verfahren und Anordnung zur Wärmebehandlung von flächigen Gegenständen**

(30) Priorität: 01.02.1999 DE 19903798
(71) Anmelder: Angewandte Solarenergie - ASE GmbH, 63755 Alzenau (DE)
(72) Erfinder: Heyer, Fritz, 22880 Wedel (DE); Roth, Peter, 63454 Hanau (DE)
(74) Vertreter: Stoffregen, Hans-Herbert, Dr. Dipl.-Phys.

(57) **Zusammenfassung**

Die Erfindung bezieht sich auf ein Verfahren zur Wärmebehandlung von flächigen Gegenständen wie Halbleiterscheiben in Form von z. B. Siliziumwafern, wobei die Gegenstände auf Trägern angeordnet und durch eine Wärmeeinrichtung insbesondere kontinuierlich gefördert werden. Um eine gezielte Behandlung eines flächigen Gegenstandes, insbesondere Halbleiterbauelementes wie Siliziumwafers auf nur einer Seite zu ermöglichen, wobei gleichzeitig ein hoher Durchsatz bei ggf. erfolgender Einbindung in einen kontinuierlichen Gesamtherstellungsprozess erreicht werden soll, wird vorgeschlagen, dass die Gegenstände flächig auf den die Gegenstände unterseitig vollständig oder nahezu vollständig abdeckenden Trägern angeordnet werden, die ihrerseits insbesondere aus Quarzglas bestehen.

## Beschreibung

Die Erfindung bezieht sich auf ein Verfahren zur Wärmebehandlung von flächigen Gegenständen wie Halbleiterscheiben in Form von z. B. Siliziumwafern, wobei die Gegenstände auf Trägern angeordnet und durch eine Wärmeeinrichtung insbesondere kontinuierlich gefördert werden. Ferner bezieht sich die Erfindung auf eine Anordnung zum Wärmebehandeln von flächigen Gegenständen, insbesondere Halbleiterscheiben wie Siliziumwafern, umfassend die Gegenstände aufnehmende Träger, eine diese durch eine Wärmeeinrichtung transportierende erste eine Transportebene aufspannende Fördereinrichtung sowie Aufgabe- und Entnahmemittel zum Aufgeben bzw. Entnehmen der Gegenstände auf die Träger bzw. von diesen.

Die kontinuierliche Wärmebehandlung, insbesondere Hochtemperaturbehandlung von Halbleiterscheiben sind für Prozesse wie Oxidation der Halbleiteroberfläche, Aufsintern von Schichten auf die Halbleiter wie etwa Metallkontakte oder andere Antireflexbeläge oder zur Dotierung des Halbleitermaterials durch Diffusion notwendig.

Bei den Anwendungsfällen Diffusion, Oxidation und Sintern von Kontakten und Antireflexschichten sind nach dem Stand der Technik jedoch verfahrensmäßig erhebliche Probleme gegeben..

Bei der Herstellung von Halbleiterbauelementen, insbesondere von Solarzellen müssen in einem oder in mehreren aufeinander folgenden Prozessschritten an der Oberfläche von Halbleiterscheiben dünne hoch dotierte Schichten erzeugt werden. Diese können entweder jeweils den entgegengesetzten Leitungstyp aufweisen als das Basismaterial, also eine hoch n-dotierte Schicht auf p-dotiertem Basismaterial oder eine hoch p-dotierte Schicht auf n-leitendem Basismaterial, oder die hoch dotierte Schicht kann von demselben Leitungstyp wie das Basismaterial sein.

Das für diesen Zweck am häufigsten eingesetzte Verfahren ist die Diffusion geeigneter Dotierstoffe wie Phosphor oder Arsen für n-leitende Schichten oder Bor bzw. Aluminium für p-leitende Schichten.

Das klassische Verfahren der Dotierung mit Phosphor ist die Diffusion im Quarzrohrofen. Bei diesem Verfahren werden die Halbleiterscheiben in Horden aus Quarz gestellt, so dass die Scheiben parallel und in konstanten Abständen zueinander stehen. Die Horden werden in ein Prozessrohr aus Quarz gestellt, das von außen durch Strahlung beheizt wird.

Im Rohr werden die Scheiben einer oxidierenden Atmosphäre ausgesetzt, die Phosphor enthält. Üblicherweise lässt man dazu Stickstoff durch einen Dotierstoff in flüssiger Form z. B. Phosphorylchlorid POCl₃ oder Phosphorbromid PBr₃ perlen und leitet diesen zusammen mit einem weiteren Strom von Stickstoff und Sauerstoff in das beheizte Prozessrohr. Seltener wird das hochgiftige Gas Phosphorwasserstoff PH₃ in das Prozessrohr geleitet.

Bei Temperaturen zwischen 800°C und 1000°C laufen im Prozessrohr folgende Reaktionen ab. Das Dotiermittel zersetzt sich und es bildet sich Phosphorpentoxid P₂O₅ und freies Cl bzw. Br. Das Phosphorpentoxid reagiert mit der Siliziumoberfläche und bildet Siliziumdioxid und Phosphor, der in das Oxid eingelagert ist.

Aus diesem Film aus Siliziumdioxid diffundiert der Phosphor dem Konzentrationsgefälle entsprechend in den Halbleiter. Die Eigenschaften der n-dotierten Schicht wie Leitfähigkeit und Eindringtiefe hängen von der Konzentration des Phosphors im Dotierfilm, der Temperatur und der Dauer der Wärmebehandlung sowie der Dotierung des Ausgangsmaterials und seiner Kristallstruktur ab.

Vorteilhaft ist, dass, da Quarzglas in sehr hoher Reinheit hergestellt werden kann, die Atmosphäre im Quarzrohrofen sehr rein gehalten werden kann. Außerdem tragen die aus den Dotierstoffen frei werdenden Halogene kontinuierlich zur Reinigung der Ofenatmosphäre bei, da sie mit Metallen flüchtige Halogenide bilden, die mit den Prozessgasen aus dem Prozessrohr herausgeführt werden.

Allerdings sind besonders für die Herstellung von Solarzellen schwerwiegende Nachteile gegeben, da die Diffusion allseitig erfolgt, der Durchsatz in den Rohröfen verhältnismäßig gering ist, das Verfahren nicht kontinuierlich, sondern in einzelnen Chargen läuft und das Einstellen der Scheiben in Quarzhorden einen erheblichen Aufwand insbesondere dann bedeutet, wenn die vor- und nachgeschalteten Prozesse kontinuierliche Prozesse sind.

Zur Herstellung von Solarzellen wird daher in zunehmendem Maße ein anderes Verfahren eingesetzt. Die Halbleiterscheiben werden in einem separaten Prozessschritt mit einem Dotierfilm beschichtet. Das kann durch Siebdruck, durch Aufschleudern oder Aufsprühen eines Films aus Phosphor-Silikat-Polymeren und organischen Lösungsmitteln oder auch verdünnter Phosphorsäure geschehen.

Die so beschichteten Scheiben laufen sodann durch einen Durchlaufofen, in dem zunächst die organischen Bestandteile des Dotierfilms abgedampft bzw. verbrannt werden, eine den Phosphor enthaltende Siliziumoxidschicht erzeugt und schließlich der Phosphor aus dem verbleibenden Silikatfilm in das Halbleitermaterial eindiffundiert wird. Das Temperaturprofil des Ofens und die Zusammensetzung der Atmosphäre im Ofen wird dabei sorgfältig an die Prozesse angepasst.

Dieses Verfahren vermeidet die oben genannten Nachteile des Quarzrohrofens, weist jedoch einen anderen gravierenden Nachteil auf. Der Ofen kann nicht vollständig metallfrei aufgebaut werden. Zumindest die erforderlich Transporteinrichtung wie -gurt muss wegen der hohen Belastung und der gewünschten langen Einsatzdauer aus Metall gefertigt werden. Üblicherweise werden dabei Geflechtsbänder aus hochtemperaturfesten Ni-Cr-Mo-Legierungen eingesetzt.

In umfangreichen Untersuchungen wurde nachgewiesen, dass Verunreinigungen aus dem Metallgeflechtsband in die Halbleiterscheiben eindiffundieren, die Lebensdauer der Minoritätsladungsträger verringern oder gar durch Ausscheidungen Kurzschlüsse im pn-Übergang verursachen und dadurch den Wirkungsgrad der Solarzellen verschlechtern. Diese Verschlechterung tritt auch dann auf, wenn der direkte Kontakt der Halbleiterscheiben mit dem Transportband vermieden wird. Der Grad der Beeinträchtigung des Wirkungsgrades steht in Zusammenhang mit der Zusammensetzung des Metallbandes und der Zusammensetzung der Halbleiterscheiben sowie deren Kristallstruktur.

Zur Passivierung von Halbleiteroberflächen bzw. zum Erstellen von Diffussionsmasken für die Photolithographie werden Halbleiterscheiben bei sehr hohen Temperaturen einer Sauerstoff bzw. Sauerstoff und Wasserdampf enthaltenden Atmosphäre ausgesetzt, um eine Oxidationsschicht auszubilden. Wird dieser Prozess in einem Durchlaufofen ausgeführt, treten dieselben wie die zuvor erläuterten Probleme auf

Sintern von Metallisierungen auf Halbleitern wird fast ausschließlich in Durchlauföfen unter kontrollierter Atmosphäre durchgeführt, da nur in Durchlauföfen die zum Erreichen eines geringen Kontaktwiderstands benötigten speziellen Temperatur-Zeitprofile auf einfache Weise erzeugt werden können. Beim Sintern von Kontakten werden kurzzeitig Temperaturen von mehr als 800°C erreicht. Dies kann dazu führen, dass - wie bei der Diffusion oder der Oxidation - Metalle aus der Ofenatmosphäre in den Halbleiter diffundieren und die Qualität der gefertigten Bauelemente verschlechtern.

Ein Verfahren zum kontinuierlichen Wärmebehandeln von Halbleiterscheiben ist der US 5,449,883 zu entnehmen. Dabei werden die Scheiben auf Schwingbalken linienförmig abstützt und mittels dieser durch eine Wärmebehandlungs- und eine Kühlzone gefördert.

Um Siliziumfilme thermisch zu behandeln, können diese zwischen Lichtquellen hindurchgeführt werden (US-Z.: Fair, J., Rapid Thermal Processing for Active Matrix Devices, Solid State Technology, August 1992, S. 47 - 52).

Der vorliegenden Erfindung liegt das Problem zugrunde, ein Verfahren und eine Anordnung der eingangs genannten Art so weiterzubilden, dass eine gezielte Behandlung eines flächigen Gegenstandes, insbesondere Halbleiterbauelementes wie Siliziumwafers auf nur einer Seite erfolgen kann, wobei gleichzeitig ein hoher Durchsatz bei ggf. erfolgender Einbindung in einen kontinuierlichen Gesamtherstellungsprozess erreicht werden soll. Auch soll ein problemloses Bestücken der Träger mit den Gegenständen möglich sein. Gleichzeitig soll sichergestellt sein, dass auch bei Anwendung hoher Temperaturen eine Verunreinigung der Gegenstände durch von den Trägern stammenden Materialien, also ein Eindiffundieren dieser unterbleibt.

Verfahrensmäßig wird das Problem im Wesentlichen dadurch gelöst, dass die Gegenstände flächig auf den die Gegenstände unterseitig vollständig oder nahezu vollständig abdeckenden Trägern angeordnet werden, die ihrerseits insbesondere aus Quarzglas bestehen. Dabei werden die Träger innerhalb der als Durchlaufofen ausgebildeten Wärmeeinrichtung derart auf einer Transporteinrichtung ausgerichtet und angeordnet, dass die Träger eine geschlossene oder weitgehend geschlossene Fläche mit einer in von der Transporteinrichtung aufgespannten Transportebene verlaufenden Breitenerstreckung aufweisen, die dem Durchlaufofen in seiner Breitenerstreckung entspricht.

Durch die erfindungsgemäße Lehre, dass die Gegenstände ganzflächig oder nahezu ganzflächig auf Quarzträgern aufliegen, ist ein Eindringen von Verunreinigungen von der Unterseite her ausgeschlossen. Da zudem die Träger den Durchlaufofen, also die Ofenkammer in zwei nahezu vollständig getrennte Teilkammern unterteilt, kann als Transporteinrichtung ein z. B. metallischer Transportgurt benutzt werden, ohne dass die Gefahr besteht, dass Metall in die Gegenstände eindiffundiert. Der oberhalb von den Trägern begrenzte Bereich der Ofenkammer kann frei von Metallen ausgebildet sein, so dass demzufolge die Gefahr von Verunreinigungen nicht besteht.

Ein besonders einfacher Verfahrensablauf bei gleichzeitig sichergestelltem hohen Durchsatz durch die Wärmeeinrichtung ergibt sich dann, wenn die Träger in einem geschlossenen, den Durchlaufofen durchsetzenden Kreislauf gefördert werden, der seinerseits die erste die Träger durch den Durchlaufofen transportierende Fördereinrichtung, eine die Träger nach Entladen der auf diesen geförderten Gegenstände auf eine zweite Fördereinrichtung umsetzende erste Übergabeeinrichtung sowie eine zweite die Träger von der zweiten Fördereinrichtung auf die erste Fördereinrichtung umsetzende Übergabeeinrichtung umfasst, wobei die erste Fördereinrichtung eine geringere Fördergeschwindigkeit als die zweite Fördereinrichtung aufweisen kann.

Damit ein problemloses Übergeben der Gegenstände auf die Träger bzw. ein Entnehmen dieser möglich ist, ist des Weiteren vorgesehen, dass die Träger vor dem Anordnen der Gegenstände auf diese und/oder nach der Entnahme zumindest zweiachsig, vorzugsweise in Längs- und Querrichtung zur Transportrichtung der ersten Fördereinrichtung ausgerichtet werden.

Nach einer weiteren hervorzuhebenden Ausgestaltung der Erfindung ist vorgesehen, dass die Träger während der Übergabe von der ersten auf die zweite Fördereinrichtung gekippt werden, um ggf. Reste von z. B. beschädigten Gegenständen zu entfernen, ohne dass es einer weiteren Säuberung bedarf.

Eine Anordnung zum Wärmebehandeln von flächigen Gegenständen, insbesondere Halbleiterbauelementen wie Siliziumwafern, umfassend die Gegenstände aufnehmende Träger, eine diese durch eine Wärmeeinrichtung transportierende erste eine Transportebene aufspannende Fördereinrichtung sowie Aufgabe- und Entnahmemittel zum Aufgeben bzw. Entfernen der Gegenstände auf die Träger bzw. von diesen, zeichnet sich dadurch aus, dass die Träger eine parallel zu der Transportebene verlaufende Auflagefläche zum flächigen bzw. weitgehenden flächigen Auflegen der Gegenstände aufweisen, wobei die Träger selbst aus Quarzmaterial bestehen. Dabei sind die Träger derart auf der ersten Fördereinrichtung angeordnet, dass diese eine nahezu geschlossene Fläche in der Transportebene bilden, wobei deren Breitenerstreckung der der Wärmeeinrichtung in Form eines Durchlaufofens angepasst ist.

Die von den Trägern gebildete Fläche unterteilt somit den Durchlaufofen in einen oberen und einen unteren Bereich, wobei der obere Bereich frei von Metallen sein sollte.

Des Weiteren ist vorgesehen, dass in jedem der durch die Träger unterteilten Bereiche Gaseinlässe oder Gasauslässe angeordnet sind, wobei die Einlässe bzw. Auslässe vorzugsweise symmetrisch zur Transportbahn bzw. der von den Trägern gebildeten Fläche angeordnet sind. Durch diese Maßnahme wird ein Gasaustausch zwischen den Bereichen, also Teilkammern weitgehend vermieden, so dass die Reinheit der Atmosphäre in der oberen metallfreien Kammer erheblich verbessert wird.

Durch all diese Maßnahmen lässt sich der Wirkungsgrad von Solarzellen um bis zu 0,8 % absolut anheben.

In weiterer Ausbildung der Erfindung ist vorgesehen, dass die Träger auf der ersten Fördereinrichtung aufgeständert angeordnet sind. Hierzu können die Träger bodenseitig als Abstützungen dienende Vorsprünge aufweisen. Die Träger selbst weisen eine platten- oder tablettförmige Gestaltung auf, wobei oberseitig Aufnahmen für die Gegenstände derart ausgebildet sind, dass diese formschlüssig erfassbar sind, um die Gegenstände auf die Träger anzuordnen bzw. von diesen zu entnehmen.

Die Fördereinrichtung selbst ist ein Band wie Metallband- oder Plattenförderer, um auch hohen Temperaturen in der Wärmeeinrichtung Stand zu halten, die insbesondere bei einem Sinterprozess erforderlich sind.

Des Weiteren ist vorgesehen, dass die Anordnung mehrere einen Kreislauf für die Träger bildende Fördereinrichtungen aufweist, umfassend die erste die Träger durch die Wärmeeinrichtung wie Durchlaufofen transportierende Fördereinrichtung, eine die Träger nach Durchlaufen der Wärmeeinrichtung und Entnahme der Gegenstände auf eine zweite Fördereinrichtung umsetzende erste Übergabeeinrichtung sowie eine die Träger auf die erste Fördereinrichtung im Bereich vor der Wärmeeinrichtung umsetzende zweite Übergabeeinrichtung. Dabei weist die zweite Fördereinrichtung im Bereich der zweiten Übergabeeinrichtung einen Pufferbereich auf bzw. ein entsprechender Bereich ist dieser vorgeordnet. Hierdurch ist sichergestellt, dass stets Träger zur Verfügung stehen, um diese mit Gegenständen zu bestücken und durch die Wärmeeinrichtung zu transportieren, so dass ein hoher Durchsatz gewährleistet ist.

Die erste und/oder zweite Übergabeeinrichtung sollte Greifelemente zum Erfassen der Träger aufweisen, wobei die Greifelemente entlang einer Traverse wie Portal zum Umsetzen der Träger von der ersten auf die zweite Fördereinrichtung und umgekehrt verschiebbar ist.

Um ein ordnungsgemäßes Ausrichten der Träger und damit ein automatisches Übergeben der Gegenstände auf die Träger bzw. Entnahme dieser von den Trägern sicherzustellen, ist des Weiteren vorgesehen, dass die Träger im Bereich der Übergabeeinrichtung zumindest in Bezug auf zwei parallel zur Transportebene verlaufende Achsen ausrichtbar sind, die sich in Transportrichtung und quer zu dieser erstrecken.

Des Weiteren umfasst die erste Übergabeeinrichtung eine ein Kippen des Trägers vorzugsweise um einen Winkel im Bereich von 60° ermöglichende Kippeinrichtung, wodurch sichergestellt ist, dass auf dem als Tablett zu bezeichnenden Träger Reste von z. B. beschädigten Gegenständen wie Siliziumwafern entfernt werden können.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung eines der Zeichnung zu entnehmenden bevorzugten Ausführungsbeispiels.

Es zeigen:
- Fig. 1: eine Prinzipdarstellung einer Anordnung zur Temperaturbehandlung von flächigen Gegenständen und

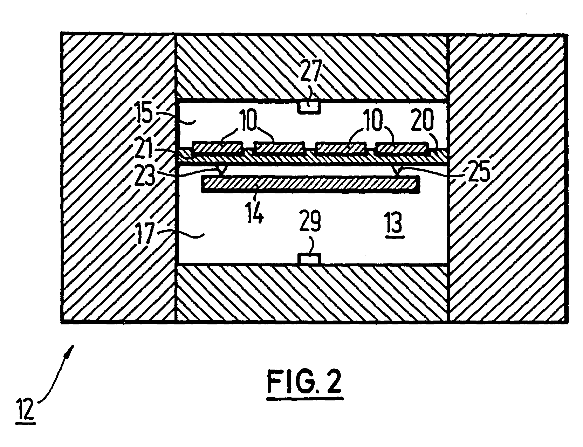

- Fig. 2: einen Schnitt durch einen Durchlaufofen.

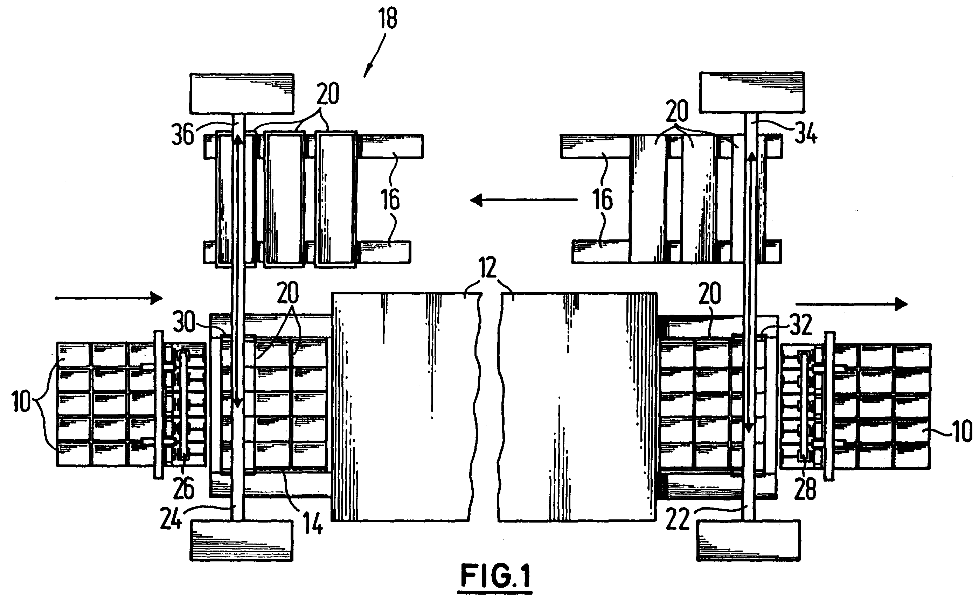

In Fig. 1 ist rein prinzipiell eine Anordnung zur insbesondere Hochtemperaturbehandlung von flächigen Gegenständen in Form von Halbleiterscheiben 10 dargestellt, ohne dass hierdurch die erfindungsgemäße Lehre eingeschränkt sein soll. Vielmehr ist die nachfolgend zu beschreibende Anordnung und das mit dieser durchzuführende Verfahren ganz allgemein zur Wärmebehandlung von flächigen Gegenständen geeignet.

Die Anordnung umfasst eine als Durchlaufofen ausgebildete Wärmeeinrichtung 12, in der die Halbleiterscheiben 10, die zur Herstellung von Solarzellen bestimmt sein können, Prozessen wie Diffusion, Oxidation oder Sinterung bei den hierzu erforderlichen Temperaturen unterworfen werden.

Die Anordnung weist des Weiteren eine erste als Transportband ausgebildete Fördereinrichtung 14, die den Durchlaufofen 12 zum Behandeln der Halbleiterscheiben oder -platten 10 durchsetzt, sowie eine zweite Fördereinrichtung 16 mit einem Pufferbereich 18 auf. Die durch die Fördereinrichtungen 14, 16 gebildeten Transportbahnen laufen zueinander entgegengesetzt, jedoch parallel, wobei eine Übergabe der Gegenstände 10 bzw. von diese aufnehmenden Trägern 20 von einer Transporteinrichtung 14 auf die andere Transporteinrichtung 16 und umgekehrt mittels Übergabeeinrichtungen 22, 24 erfolgt.

Um die Gegenstände 10 auf die Träger 20 aufzugeben bzw. von diesen zu entnehmen, sind Aufgabe und Entnahmeeinrichtungen 26, 28 in Form von z. B. Mehrfachgreifern vorgesehen, durch die die Gegenstände 10, also im Ausführungsbeispiel die Halbleiterbauelemente, formschlüssig in ihren Randbereichen erfasst werden, wodurch eine Beschädigung insbesondere der Oberfläche ausgeschlossen ist.

Die Träger 20 bestehen aus Quarz und können als Quarztabletts bezeichnet werden, wobei vorzugsweise auf einem Träger 20 mehrere Gegenstände in einer Reihe quer zur Transportrichtung des Bandes 14 angeordnet werden. Selbstverständlich können auch mehrere Träger nebeneinander in einer Reihe quer zur Transportrichtung vorgesehen sein. Unabhängig von der Ausbildung der Träger 20 sind diese jedoch derart zueinander ausgerichtet und aneinandergereiht und weisen eine Erstreckung quer zur Transportrichtung derart auf, dass sich eine nahezu geschlossene Fläche ergibt, deren Breitenerstreckung der des Durchlaufofens 12, d. h. dessen Ofenkammer 13 so angepasst ist, dass die Träger 20 die Kammer 13 in einen oberen Bereich 15 und einen unteren Bereich 17 unterteilen, wodurch ein Gasaustausch zwischen den Bereichen 15, 17 weitgehend ausgeschlossen werden soll.

Die Gegenstände 10 selbst liegen flächig auf den Trägern 20 auf, so dass nur deren freie obere Seite unmittelbar dem Durchlaufofen 12 und damit in diesem vorhandenen Gasen ausgesetzt ist.

Die Träger 20 können zum eindeutigen Positionieren der Gegenstände 10 entsprechende Nester 21 aufweisen, wobei die Nester 21 in Bezug auf die Geometrie der Gegenstände 10 derart bereichsweise abweichend ausgebildet sind, dass die Gegenstände mittels der Greifer 26 formschlüssig erfassbar und ablegbar bzw. mittels der Greifer 28 aus den Nestern nach Durchlaufen des Ofens 12 von den Trägern 20 entnommen werden können.

Hierzu weisen die Nester 21 oder Ausnehmungen im Bereich der quer zur Transportrichtung verlaufenden Längsränder der Gegenstände 10 Erweiterungen auf, damit die Greifelemente die Gegenstände 10 erfassen können.

Anstelle von Nestern 21 können auch Stege oder sonstige Positioniermittel vorgesehen sein, um die Gegenstände 10 eindeutig auf den Trägern 20 zu positionieren, so dass ein unkontrolliertes Verrücken beim Transport nicht erfolgen kann.

Die Träger 20 werden vor dem Beschicken mit den Gegenständen 10 über vorzugsweise als Greifer ausgebildete Justiermittel 30 sowohl in Längsrichtung zur Transportrichtung des Transportbandes 14 als auch quer hierzu derart ausgerichtet, dass die Gegenstände 10 ordnungsgemäß abgelegt werden können. Auch erfolgt nach Verlassen des Ofens 12 im Bereich der Übergabeeinrichtung 22 mit entsprechenden Elementen wie Greifen 32 eine Ausrichtung.

Um die Träger 20 von dem Transportband 14 nach Entfernen der Gegenstände auf die zweite Fördereinrichtung 16 umzusetzen, ist die Übergabeeinrichtung 22 vorgesehen, die nicht näher dargestellte Greifelemente aufweist, die entlang eines Portals 34 verfahrbar sind. Entsprechend ist die Übergabeeinrichtung 24 ausgebildet, um folglich mittels entlang eines Portals 36 verfahrbaren Greifers die Träger 20 von der Transporteinrichtung 16 auf das Transportband 14 umzusetzen.

Damit die Träger 20 oder Quarztabletts problemlos von dem Transportband 14 angehoben werden können, sind erstere aufgeständert. Hierzu können von der Unterseite der Träger 20 Abstandselemente 23, 25 ausgehen.

Des Weiteren ist vorgesehen, dass der die Träger 20 von dem Transportband 14 auf die Fördereinrichtung 16 übergebende Greifer während des Verfahrens entlang des Portals 34 verschwenkt werden können, so dass die Träger 20 um ihre Längsachse um einen Winkel von zum Beispiel 60° gekippt werden. Hierdurch können auf dem Träger 20 vorhandene Bruchstücke von z. B. beschädigten Gegenständen abgeworfen, also entfernt werden.

Dadurch, dass die Träger 20 beim Durchlaufen des Ofens 12 eine nahezu geschlossene Fläche mit einer Breitenerstreckung aufweisen, die der des Ofens 12 entspricht, wird dieser erwähntermaßen in eine obere und eine untere Kammer 17, 15 unterteilt. Somit kann das Transportband 14 aus Metall bestehen, ohne dass die Gefahr erwächst, dass Metall in die Gegenstände 10 hineindiffundiert, sofern die obere Teilkammer 15 metallfrei ist.

Des Weiteren ist vorgesehen, dass oberhalb und unterhalb des Transportbandes 14 vorzugsweise symmetrisch zu einer durch das Transportband 14 aufgespannten Symmetrieebene Gasein- und Gasauslässe 27, 29 wie Gasabsaugen vorhanden sind, wodurch ein Gasaustausch zwischen der oberen und unteren Teilkammer weitgehend verhindert wird. Infolgedessen kann die Reinheit der Atmosphäre in der oberen Teilkammer, in der die Gegenstände 10 wärmebehandelt werden, erheblich verbessert werden. Bei der Behandlung von Solarzellen ist mit diesen Maßnahmen eine Erhöhung des Wirkungsgrades um bis zu 0,8 % absolut erreichbar.

## Patentansprüche

1. Verfahren zur Wärmebehandlung von flächigen Gegenständen wie Halbleiterscheiben in Form von z. B. Siliziumwafern, wobei die Gegenstände auf Trägern angeordnet durch eine Wärmeeinrichtung insbesondere kontinuierlich gefördert werden,
**dadurch gekennzeichnet,**
dass die Gegenstände flächig oder nahezu flächig auf den die Gegenstände unterseitig vollständig oder nahezu vollständig abdeckenden Trägern angeordnet werden.

2. Verfahren nach Anspruch 1,
**dadurch gekennzeichnet,**
dass die Träger innerhalb der als Durchlaufofen ausgebildeten Wärmeeinrichtung derart auf einer Transporteinrichtung ausgerichtet und angeordnet werden, dass die Träger eine geschlossene oder weitgehend geschlossene Fläche mit einer in von der Transporteinrichtung aufgespannten Transportebene verlaufenden Breitenerstreckung aufweisen, die dem Durchlaufofen in seiner Breitenerstreckung entspricht.

3. Verfahren nach Anspruch 1 oder 2,
**dadurch gekennzeichnet,**
dass die Träger in einem geschlossenen den Durchlaufofen durchsetzenden Kreislauf gefördert werden, der seinerseits die erste die Träger durch den Durchlaufofen transportierende Fördereinrichtung, eine die Träger nach Entladen der auf diesen geförderten Gegenstände auf eine zweite Fördereinrichtung umsetzende erste Übergabeeinrichtung sowie eine zweite die Träger von der zweiten Fördereinrichtung auf die erste Fördereinrichtung umsetzende Übergabeeinrichtung umfasst, wobei insbesondere die erste Fördereinrichtung eine geringere Fördergeschwindigkeit als die zweite Fördereinrichtung aufweist.

4. Verfahren nach zumindest einem der vorhergehenden Ansprüche,
**dadurch gekennzeichnet,**
dass die Träger vor dem Anordnen der Gegenstände auf diese und/oder nach der Entnahme zumindest zweiachsig, vorzugsweise in Längs- und Querrichtung zur Transportrichtung der ersten Fördereinrichtung ausgerichtet werden und dass insbesondere die Gegenstände auf die Träger bzw. von diesen automatisch aufgesetzt bzw. entfernt werden.

5. Verfahren nach zumindest einem der vorhergehenden Ansprüche,
**dadurch gekennzeichnet,**
dass die Träger während der Übergabe von der ersten auf die zweite Fördereinrichtung vorzugsweise um ihre Längsachse verschwenkt bzw. gekippt werden.

6. Anordnung zum Wärmebehandeln von flächigen Gegenständen (10), insbesondere Halbleiterscheiben wie Siliziumwafern, umfassend die Gegenstände aufnehmende Träger (20), eine diese durch eine Wärmeeinrichtung (12) transportierende erste eine Transportebene aufspannende Fördereinrichtung (14) sowie Aufnahme- und Entnahmemittel (26, 28) zum Aufgeben bzw. Entfernen der Gegenstände auf die Träger bzw. von diesen,
**dadurch gekennzeichnet,**
dass die Träger (20) eine parallel zu der Transportebene verlaufende Auflagefläche zum flächigen bzw. weitgehenden flächigen Auflegen der Gegenstände (10) aufweisen.

7. Anordnung nach Anspruch 6,
**dadurch gekennzeichnet,**
dass die insbesondere aus Quarzmaterial bestehenden Träger (20) derart auf der ersten Fördereinrichtung (14) angeordnet sind, dass diese eine nahezu geschlossene Fläche in der Transportebene bilden, wobei die Fläche in ihrer Breitenerstreckung der der Wärmeeinrichtung (12) in Form eines Durchlaufofens zur Unterteilung des Durchlaufofens in eine obere und eine untere Ofenteilkammer (15, 17) angepasst ist, und wobei insbesondere die obere Ofenteilkammer (15) frei von Metallen ist.

8. Anordnung nach Anspruch 6 oder 7,
**dadurch gekennzeichnet,**
dass in jedem der durch die Träger (20) unterteilten Teilkammer (15, 17) Gaseinlässe und/oder Gasauslässe (25, 27) angeordnet sind, wobei die Gasein- und/oder -auslässe vorzugsweise symmetrisch zur Transportbahn bzw. der von den Trägern (20) gebildeten Fläche angeordnet sind.

9. Anordnung nach zumindest einem der vorhergehenden Ansprüche,
**dadurch gekennzeichnet,**
dass die Träger (20) auf der ersten Fördereinrichtung (14) aufgeständert angeordnet sind und/oder dass die Träger (20) eine platten- oder tablettförmige Gestalt und oberseitig Aufnahmen (21) für die Gegenstände (10) derart aufweisen, dass diese formschlüssig erfassbar sind.

10. Anordnung nach zumindest einem der vorhergehenden Ansprüche,
**dadurch gekennzeichnet,**
dass die Erstreckung der Träger (20) quer zur Transportrichtung gleich oder in etwa gleich der inneren lichten Weite der Wärmeeinrichtung (12) in diesem Bereich ist.

11. Anordnung nach zumindest einem der vorhergehenden Ansprüche,
**dadurch gekennzeichnet,**
dass die Anordnung mehrere einen Kreislauf für die Träger (20) bildende Fördereinrichtungen aufweist, umfassend die erste die Träger durch die Wärmeeinrichtung (12) wie Durchlaufofen transportierende Fördereinrichtung (14), eine die Träger nach Durchlaufen der Wärmeeinrichrung und Entnahme der Gegenstände auf eine zweite Fördereinrichtung (16) umsetzende erste Übergabeeinrichtung (22) sowie eine die Träger auf die erste Fördereinrichtung im Bereich vor der Wärmeeinrichtung umsetzende zweite Übergabeeinrichtung (24).

12. Anordnung nach zumindest einem der vorhergehenden Ansprüche,
**dadurch gekennzeichnet,**
dass die erste und/oder zweite Übergabeeinrichtung (22, 24) Greifelemente zum Erfassen der Träger (20) aufweisen, wobei insbesondere die Greifelemente entlang einer Traverse wie Portal (34, 36) zum Umsetzen der Träger von der ersten auf die zweite Fördereinrichtung (14, 16) und umgekehrt verschiebbar sind, und dass vorzugsweise die zweite Fördereinrichtung (16) im Bereich der zweiten Übergabeeinrichtung (24) einen Pufferbereich aufweist bzw. ein entsprechender Pufferbereich dieser zugeordnet ist.

13. Anordnung nach zumindest einem der vorhergehenden Ansprüche,
**dadurch gekennzeichnet,**
dass die Träger (20) im Bereich der Übergabeeinrichtung (22, 24) zumindest in Bezug auf zwei parallel zur Transportebene verlaufende Achsen, vorzugsweise in Transportlängsrichtung und quer zu dieser ausrichtbar sind, wobei die erste Übergabeeinrichtung (22) vorzugsweise eine ein Kippen des Trägers (20) um einen Winkel im Bereich von zum Beispiel 60° ermöglichende Kippeinrichtung aufweist.

14. Anordnung nach zumindest einem der vorhergehenden Ansprüche,
**dadurch gekennzeichnet,**
dass der ersten Transporteinrichtung (14) Greifelemente (24, 26) zum formschlüssigen Erfassen der Gegenstände (10) zum Aufgeben bzw. Entnehmen dieser auf die Träger (20) bzw. von diesen vor- und nachgeordnet sind.
